# EUROPEAN PATENT APPLICATION

(11) **EP 1 689 055 A1**
(43) Date of publication of application: **09.08.2006**
(21) Application number: 04819329.6
(22) Date of filing: 12.11.2004
(51) Int. Cl.: H01S 5/024

(54) **LASER SYSTEM**

(30) Priority: 27.11.2003 JP 2003397000
(71) Applicant: SONY CORPORATION, Tokyo 141-0001 (JP)
(72) Inventor: TANAKA, Tomiji, c/o Sony Corporation, Tokyo 1410001 (JP)
(74) Representative: Müller, Frithjof E.
(86) International application number: PCT/JP2004/017217
(87) International publication number: WO 2005/053123

(57) **Abstract**

A laser systemt(1) is composed of a temperature control section(12)that has a Peltier device (9), a heat sink(10), and a base plate(11); and a laser section(8) that has a laser diode(2), a lens(3), a grating(5), a first support member(5), and second support member(6). The heat sink (10) is connected to the base plate (11) and is perpendicular thereto. The Peltier device(9)is connected to the heat sink (10). The second support member (6) of the laser section(8)is connected to the Peltier device(9)so that one surface of the Peltier device(9)is connected to the heat sink(10) and the other surface of the Peltier device(9)is connected to the second support member(6). Heat generated in the laser diode (2), the lens(3), the first support member (5), and so forth, which compose an external cavity type semiconductor laser, is transmitted through the second support member(6), the Peltier device(9), the heat sink (10), and the base plate (11). When the distance by which the base plate (11) and the laser section(8)are spaced apart is a predetermined value or more, heat transmitted to the laser section(8)can be effectively blocked.

## Description

### Technical Field

The present invention relates to a laser system that contains an external cavity type semiconductor laser, more specifically, to a laser system whose temperature can be accurately controlled.

### Background Art

In recent years, since semiconductor lasers feature small size and low power consumption, they have been used in many information devices. These semiconductor lasers include an external cavity type semiconductor laser that stabilizes the wavelength of oscillation light with external incident light having a predetermined wavelength.

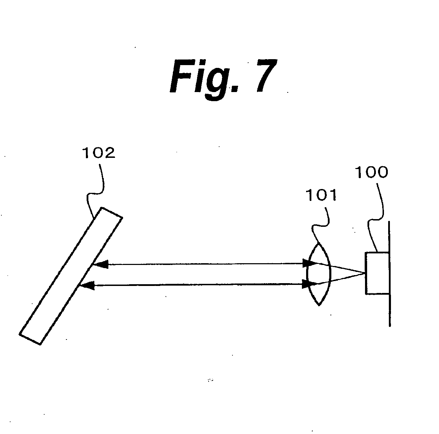

With reference to Fig. 7, a typical Littrow type semiconductor laser will be described. Multiple longitudinal laser light emitted from a semiconductor laser device such as a laser diode 100 is collimated by a lens 101 and entered into a grating 102. The grating 102 outputs light having a predetermined wavelength as primary diffraction light of the incident light according to the arrangement angle. The primary diffraction light is reversely injected into the laser diode 100 through the lens 101. As a result, the laser diode 100 oscillates with the injected primary diffraction light and emits single mode light. The wavelength of the emitted light is the same as the wavelength of the light returned from the grating 102.

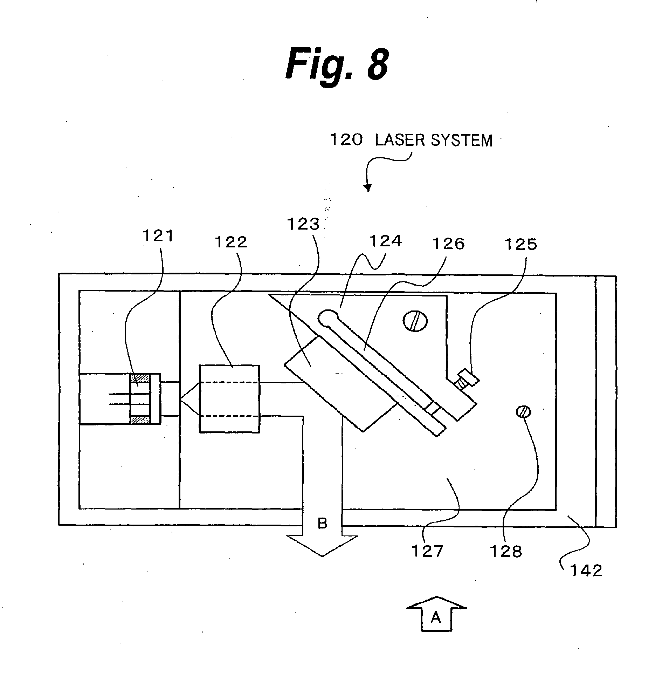

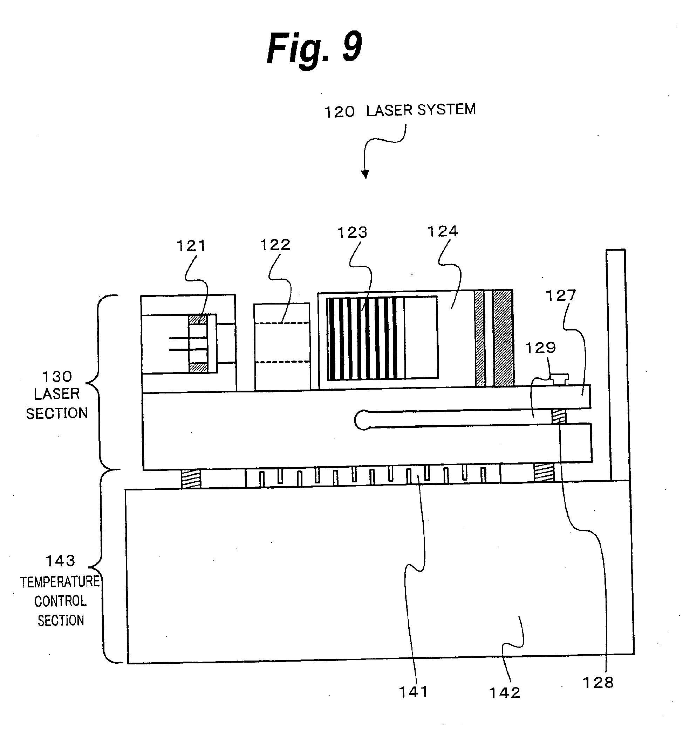

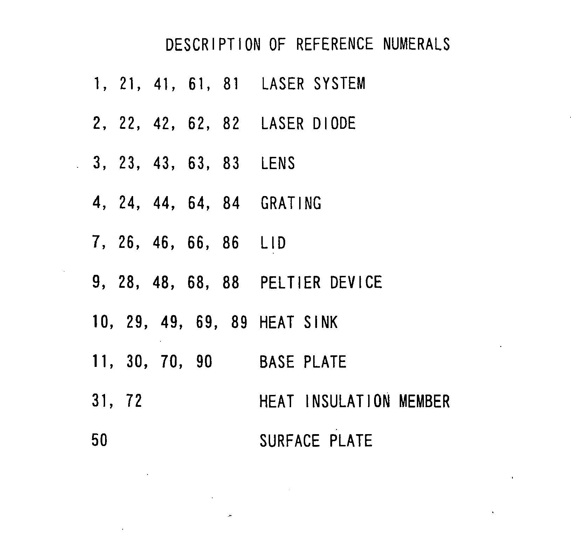

Next, with reference to Fig. 8 and Fig. 9, the structure of a commercial laser system that contains the typical external cavity semiconductor laser will be described. Fig. 8 is a plan view showing a laser system 120. Fig. 9 is a front view showing the laser system 120 seen from the direction denoted by arrow A shown in Fig. 8. The structure of the laser system 120 is the same as the structure of the laser system described in L. Ricci, et. al., "A compact grating - stabilized diode laser system for atomic pliysics," Optics Communications, 117 1995, pp 541-549.

The laser system 120 shown in Fig. 8 and Fig. 9 is composed of a laser section 130 that has a laser diode 121, a lens 122, a grating 123, a first support member 124, a first screw 125, a first groove 126, a second support member 127, a second screw 128, and a second groove 129; and a temperature control section 143 that has a Peltier device 141 and a heat sink 142.

As is clear from Fig. 8 and Fig. 9, in the laser system 120, optical components such as the lens 122, the grating 123, and so forth are horizontally arranged. The optical path of the laser light is nearly in parallel with the arrangement surface of the laser system 120. The temperature control section 143 is disposed below the laser section 130. The temperature control section 143 controls the temperatures of individual components such as the laser diode 121 and the lens 122 of the laser section 130. The temperature control section 143 keeps the temperature of the laser diode 121 constant, allowing an output of the light source to be stable. When the thermal expansion of the laser section 130 is suppressed, the size of the external cavity containing the grating 123 and the first support member 124 can be kept constant.

As shown in Fig. 7, in the laser system 120, by varying the arrangement angle of the grating 123, the wavelength of the oscillation light of the laser diode 121 is adjusted. The grating 123 is held by the first support member 124. The first support member 124 has the first groove 126. By turning the first screw 125 disposed on the first support member 124, the space of the first groove 126 is widened or narrowed. As a result, the horizontal arrangement angle of the grating 123 slightly varies.

The similar mechanism is disposed to adjust the vertical angle of the grating 123. The first support member 124 that supports the grating 123 is held by the second support member 127. The second support member 127 has the second groove 129. Likewise, by turning the second screw 128 disposed in the second support member 127, the space of the second groove 129 is partly widened or narrowed. As a result, the vertical arrangement angle of the first support member 124 and the grating 123 slightly varies.

As shown in Fig. 9, the temperature control section 143 is composed of the Peltier device 141 and the heat sink 142 that also has a function as a base. When current flows in one direction of the Peltier device 141, one (first) surface thereof heats up, whereas the other (second) surface thereof cools down. When the current flow direction is reversed, the first surface of the Peltier device 141 cools down, whereas the second surface thereof heats up.

When the Peltier device 141 is used, even if one surface thereof is cooled down at -10 °C against the ambient temperature, the other surface is not heated up at +10 °C against the ambient temperature. This is because heat generated in the Peltier device 141 is added to the temperature of the other surface.

In the related art shown in Fig. 8 and 9, when the laser section 130 disposed above the Peltier device 141 is heated up, no problem will occur. When the laser section 130 is heated up at +20 °C against the ambient temperature, even if the Peltier device 141 is made of a single substance, the temperature of the lower surface of the Peltier device 141 is at most around minus several degree centigrade against the ambient temperature. In addition, the large heat sink 142 is disposed below the Peltier device 141. The heat sink 142 diffuses the low temperature.

However, when the laser section 130 is cooled down, a problem will occur. When the laser section 130 is set at -10 °C against the ambient temperature, the temperature of the lower surface of the Peltier device 141 will become around plus several ten degree centigrade against the ambient temperature. The temperature of the heat sink 142 will become around +10 °C against the ambient temperature. In this case, since the laser section 130 is disposed above the heat sink 142, heated air heats up the laser section 130. Thus, the laser section 130 is hardly cooled down.

Various applications of the external cavity type semiconductor laser have been proposed. One of these applications is a holography memory writer expected as a next generation storage. The holography memory writer is expected to be a next generation storage. The holography memory writer is considered to be used for a personal computer. In this case, since the internal temperature of the personal computer is high, when the external cavity type semiconductor laser is used, it will be cooled down.

However, in this case, since the external cavity type semiconductor laser is one component of the holography memory writer, the laser system needs to be small. Thus, it is not practical to cool down the external cavity type semiconductor laser with a large heat sink.

In a personal computer, an internal CPU is contacted with a heat sink so that heat generated in the CPU is transmitted to the heat sink. The heated heat sink is cooled down by an air blow of a fan that is rotated at high speed. Thus, when the laser system is used as a component of the holography memory writer and is build in a personal computer, the laser system may be cooled down by such a high-speed fan like the CPU.

However, the holography needs highly accurate radiation with two beams of laser light. Thus, it is necessary to suppress the vibration of the external cavity type semiconductor laser as much as possible. Thus, it is not suitable to use a high-speed fan that largely vibrates the external cavity type semiconductor laser.

Therefore, an object of the present invention is to provide a laser system that is totally miniaturized.

Another object of the present invention is to provide a laser system that suppresses the vibration of a laser section and effectively cools down it.

### Disclosure of the Invention

The present invention is a laser system, comprising a base plate, a heat sink that is connected to the base plate and that is nearly perpendicular thereto, a heat generation device or a heat absorption device that is connected to the heat sink and that is nearly perpendicular to the base plate, and a laser section that is connected to the heat generation device or the heat absorption device and that is nearly perpendicular to the base plate, one surface of the heat generation device or the heat absorption device being connected to the laser section, the other surface of the heat generation device or the heat absorption device being connected to the heat sink, wherein the laser section has a semiconductor laser device, a lens, a grating, and a support member, the semiconductor laser device, the lens, and the grating composing an external cavity type semiconductor laser, the support member supporting the external cavity type semiconductor laser, wherein the laser section is connected to the heat generation device or the heat absorption device connected to the heat sink by the support member, and wherein the external cavity type semiconductor laser is covered by the support member and a lid that has heat resistance.

In addition, the present invention is a laser system, comprising a heat sink that is directly connected to a surface plate and that is nearly perpendicular to the surface plate, a heat generation device or a heat absorption device that is connected to the heat sink and that is nearly perpendicular to the surface plate, and a laser section that is connected to the heat generation device or the heat absorption device and that is nearly perpendicular to the surface plate, one surface of the heat generation device or the heat absorption device being connected to the laser section, the other surface of the heat generation device or the heat absorption device being connected to the heat sink, wherein the laser section has a semiconductor laser device, a lens, a grating, and a support member, the semiconductor laser device, the lens, and the grating composing an external cavity type semiconductor laser, the support member supporting the external cavity type semiconductor laser, wherein the laser section is connected to the heat generation device or the heat absorption device connected to the heat sink by the support member, and wherein the external cavity type semiconductor laser is covered by the support member and a lid that has heat resistance.

### Brief Description of Drawings

Fig. 1 is a schematic diagram showing the structure of a laser system according to a first embodiment of the present invention;
Fig. 2 is a schematic diagram showing the structure of a laser system according to a second embodiment of the present invention;
Fig. 3 is a schematic diagram showing the structure of a laser system according to a third embodiment of the present invention;
Fig. 4 is a schematic diagram showing the structure of a laser system according to a fourth embodiment of the present invention;
Fig. 5 is a schematic diagram showing a specific example of the structure of a laser system;
Fig. 6 is a schematic diagram showing a specific example of the structure of a laser system;
Fig. 7 is a schematic diagram describing the structure of an external cavity type semiconductor laser;
Fig. 8 is a schematic diagram showing the structure of a laser system according to the related art; and
Fig. 9 is a schematic diagram showing the structure of the laser system shown in Fig. 8, the laser system being seen from one side.

### Best Modes for Carrying out the Invention

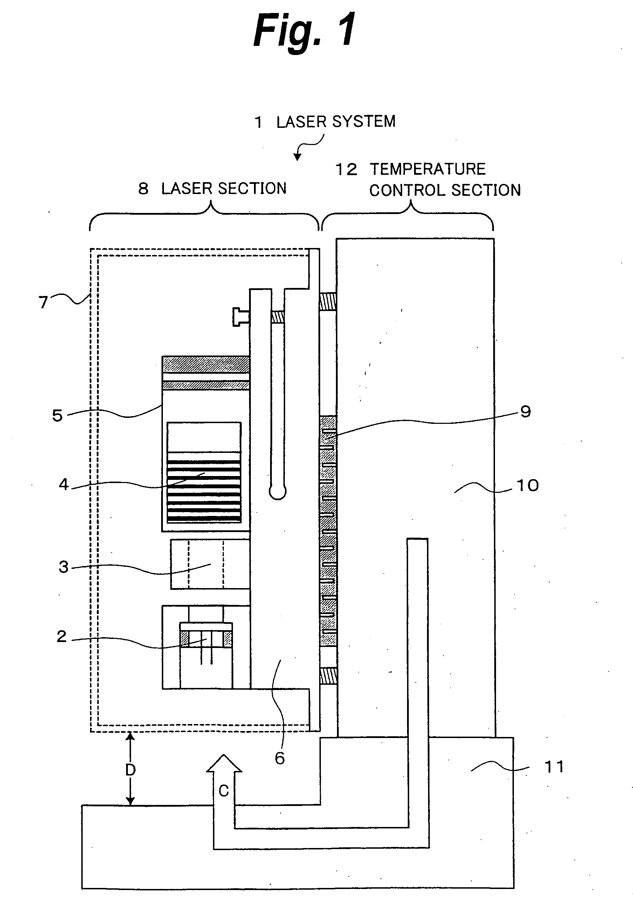

First, with reference to Fig. 1, the structure of a laser system 1 according to a first embodiment of the present invention will be described. The laser system 1 is composed of a laser section 8 that has a laser diode 2, a lens 3, a grating 4, a first support member 5, a second support member 6, and a lid 7; and a temperature control section 12 that has a Peltier device 9, a heat sink 10, and a base plate 11. The laser diode 2, the lens 3, the grating 4, and so forth are covered by the lid 7 of the laser section 8 and the second support member 6. Thus, the lid 7 and the second support member 6 block air from entering into and exiting from the laser section 8 so that the temperatures of the laser diode 2, the lens 3, the grating 4, and so forth are kept constant.

The structures of the other components of the laser section 8 are basically the same as those of the laser section 130 shown in Fig. 8 and Fig. 9. In the related art, the optical components such as the laser diode 121, the lens 122, the grating 123, and so forth are horizontally arranged on the arrangement surface of the laser system 120. In contrast, according to the first embodiment, the optical components are arranged perpendicular to the arrangement surface of the laser system 1.

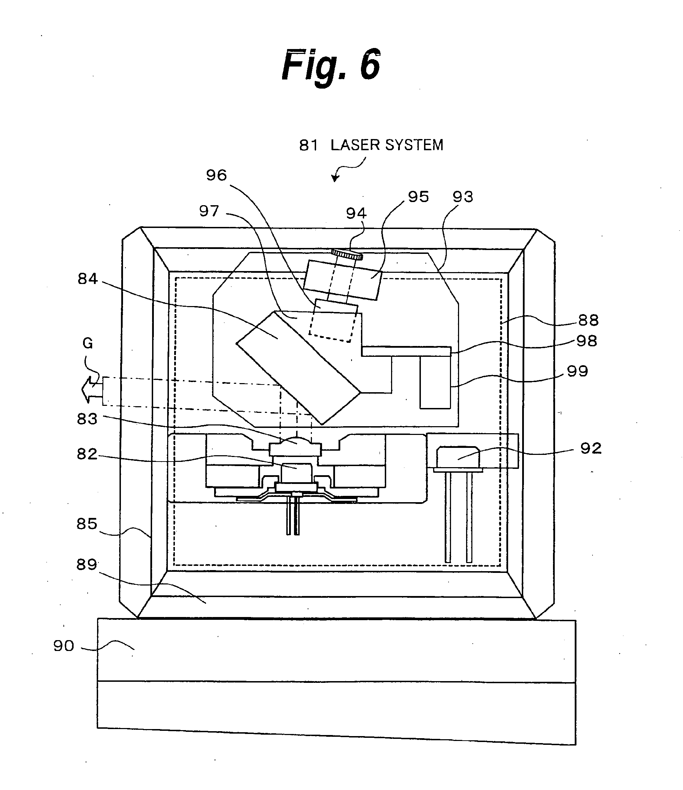

A temperature sensor (not shown) is disposed in the vicinity of the laser diode 2. The direction and amount of the current that flows in the Peltier device 9 are decided according to temperature data obtained by the temperature sensor so that the temperature of the laser section 8 is properly controlled. The position of the temperature sensor will be described with reference to Fig. 6.

Unlike with the related art, the temperature control section 12 is disposed on one side of the laser section 8. More specifically, the heat sink 10 is connected to the Peltier device 9. The Peltier device 9 is connected to the second support member 6 of the laser section 8. They need to be connected so that at least heat is transmitted therebetween for example by closely contacting them. A buffer member may be interposed between the heat sink 10 and the Peltier device 9 and between the Peltier device 9 and the second support member 6. Heat is transmitted between the grating 4 and the heat sink 10 through the first support member 5, the second support member 6, and the Peltier device 9.

In such a structure, heat generated in the laser diode 2 and so forth is transmitted to the heat sink 10 through the second support member 6 and the Peltier device 9. The heat is further transmitted to the base plate 11. Since the heat sink 10 is disposed on one side of the laser section 8, it is not heated up with heated air that rises from the heat sink 10 unlike with the laser system 1 according to the related art. From this point, it can be said that heat of the heat sink 10 is hardly transmitted to the laser section 8.

According to this embodiment, the laser diode 2 is used. Instead, another type of a semiconductor laser device may be used. According to this embodiment, the Peltier device 9 is used to control the temperature of the laser section 8. Instead, another type of a heat absorption device may be used. Instead, the temperature of the laser section 8 may be controlled only with a heat generation device. Likewise, these devices may be used in the following embodiments.

This advantageous arrangement of the heat sink 10 and the laser section 8 is facilitated when the base plate 11 is horizontally disposed against the ground. In other words, the laser section 8 needs to be free from a path of air that is heated by the heat sink 10 and that rises.

However, according to the first embodiment, there is a possibility of which heat is transmitted to the laser section 8 on a route denoted by arrow C. When the laser section 8 is set at -10 °C against the ambient temperature, the heat sink 10 is heated up by 40 °C or higher through the Peltier device 9. The heat is transmitted to the base plate 11 on the route denoted by arrow C. The heat also heats up the lid 7 through air interposed between the base plate 11 and the lid 7. Thus, the laser section 8 is indirectly heated up by the heat of the lid 7.

In this case, although the laser section 8 is cooled down by the Peltier device 9 as described above, since the amount of heat transmitted on the route denoted by arrow C is much larger than the amount of heat cooled down by the Peltier device 9, the laser section 8 is heated up.

However, this situation can be solved when the base plate 11 and the lid 7 shown in Fig. 1 are spaced apart by predetermined distance D. When the laser section 8 is set at -10 °C against the ambient temperature, if the distance D is around 10 mm or more, heat transmitted from the base plate 11 to the lid 7 can be remarkably decreased. When the laser section 8 is set at -10 °C against the ambient temperature, it is expected that the laser system 1 is used for a holography memory writer. When the laser section 8 is excessively cooled down, it should be noted that heat generated in the heat sink 10 may adversely affect other than the laser section 8.

When the laser section 8 is heated up, even if the laser section 8 is set at +20 °C against the ambient temperature, the distance D needs to be around 5 mm. Since the temperature of the heat sink 10 does not decrease by at most 5 °C against the ambient temperature, cold air transmitted to the laser section 8 on the route denoted by arrow C is small.

The lid 7 is made of a material that has a heat insulation effect, namely a material that has low thermal conductivity, such as heat resistance plastic. As the thickness of the lid 7 is decreased, the heat insulation effect is improved.

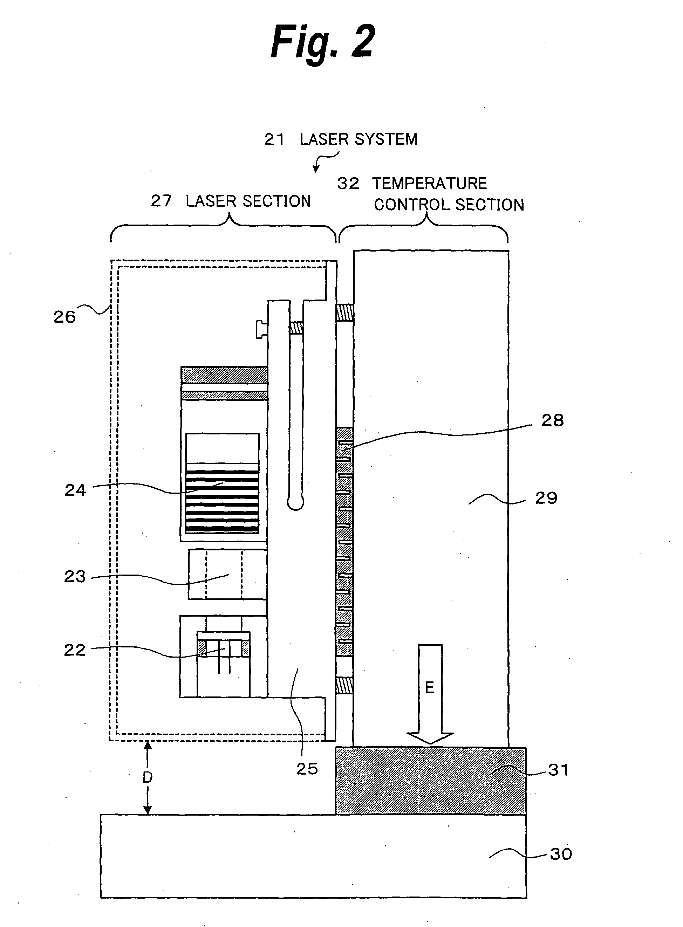

Next, with reference to Fig. 2, the structure of a laser system 21 according to a second embodiment of the present invention will be described. In the laser system 1 according to the first embodiment, heat is transmitted on the route denoted by arrow C shown in Fig. 1. Thus, there is a heat source below the laser section 8. In contrast, according to the second embodiment, a heat insulation member is disposed below a heat sink to block heat from being transmitted to a laser section.

The laser system 21 is composed of a laser section 27 that has a laser diode 22, a lens 23, a grating 24, a second support member 25, and a lid 26; and a temperature control section 32 that has a Peltier device 28, a heat sink 29, a heat insulation member 31, and a base plate 30. The structure of the laser system 21 according to the second embodiment is the same as the structure of the laser system 1 according to the first embodiment except that a part of the base plate 30 is the heat insulation member 31.

The heat insulation member 31 blocks heat from being transmitted on the route denoted by arrow C shown in Fig. 1 (namely, the heat insulation member 31 blocks heat generated in the heat sink 29 from being transmitted in the direction denoted by arrow E). The heat insulation member 31 may be made of a material having a heat insulation effect, namely low thermal conductivity. The material of the heat insulation member 31 is for example foamed plastic. Instead, the heat insulation member 31 may be made of a combination of several types of materials.

However, like the first embodiment, to prevent heat generated in the base board 30 from heating up the laser section 27, it is preferred that the distance D by which the laser section 27 and the base board 30 are spaced apart be 10 mm or more.

In addition, since the heat insulation member 31 blocks heat from escaping, the temperature of the heat sink 29 becomes high. As a result, the temperature of the laser section 27 may not be properly controlled. However, in such a situation, when the laser section 27 is set at +20 °C against the ambient temperature, the temperature of the laser section 27 can be properly controlled. Since the temperature of the heat sink 29 does not lower by at most 5 °C against the ambient temperature, the heat insulation member 31 effectively blocks cold air from being transmitted to the laser section 8.

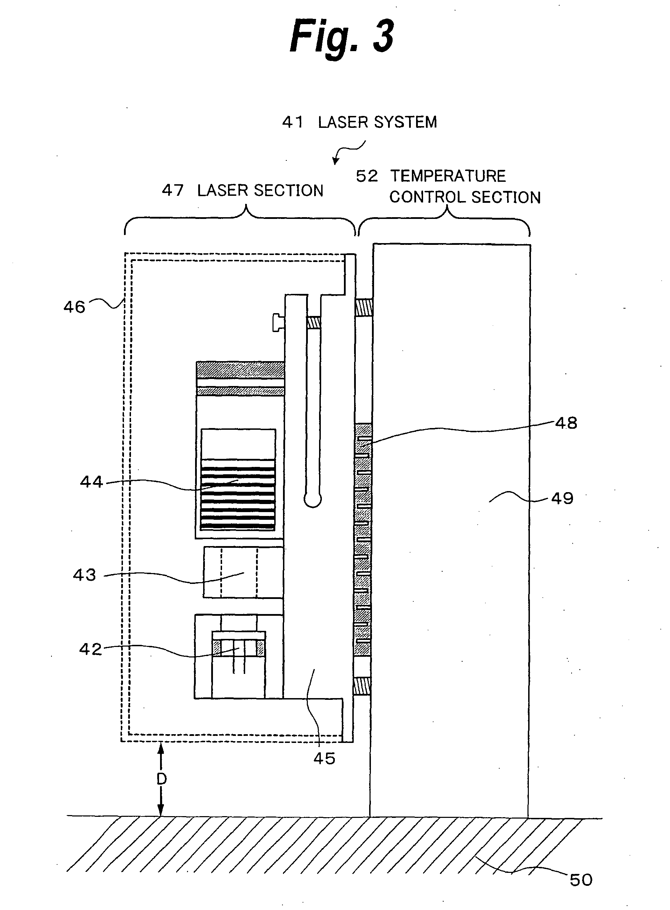

Next, with reference to Fig. 3, the structure of a laser system 41 according to a third embodiment of the present invention will be described. The laser system 1 according to the first embodiment and the laser system 21 according to the second embodiment have the base plates 11 and 30 at their lower portion, respectively. However, according to the third embodiment, a heat sink 49 is directly mounted on a surface plate 50 or the like. In this case, heat is transmitted to a laser section 47 through the surface plate 50 or the like on the same route denoted by arrow C shown in Fig. 1. Thus, the distance D by which the laser section 47 and the surface plate 50 are spaced apart needs to be 10 mm or more.

The surface plate is a flat plate or block that has an accurately flat surface. The surface plate is used to accurately align a measurement instrument and so forth.

The other structure of the laser system 41 according to the third embodiment is the same as that of the laser system 1 according to the first embodiment. In other words, the laser system 41 is composed of the laser system 47 that has a laser diode 42, a lens 43, a grating 44, a second support member 45, and a lid 46; and a temperature control section 52 that has a Peltier device 48, the heat sink 49, and the surface plate 50.

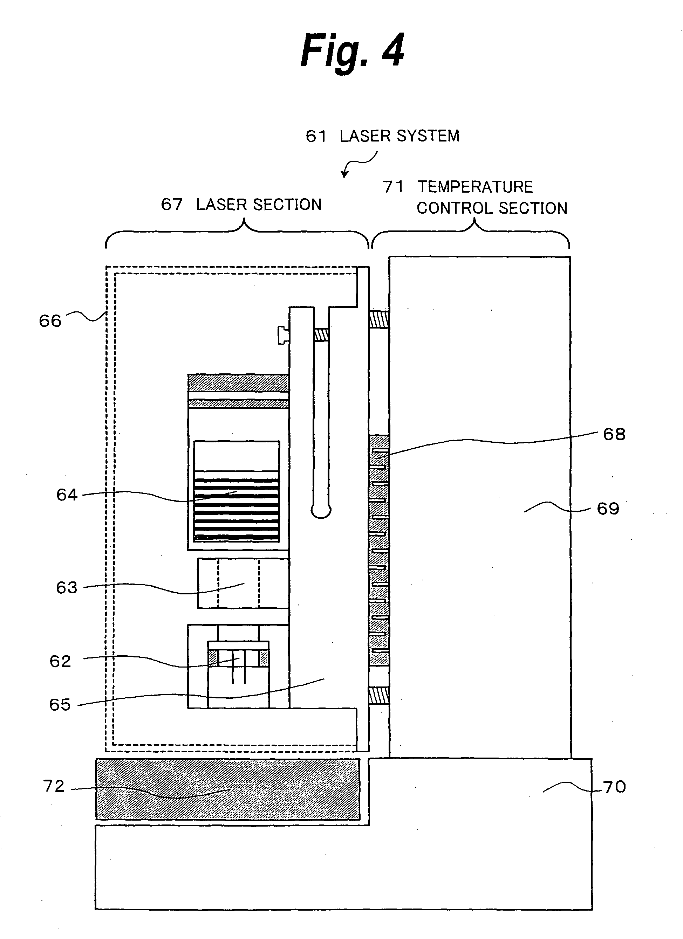

Next, with reference to Fig. 4, the structure of a laser system 61 according to a fourth embodiment of the present invention will be described. The laser system 61 according to this embodiment is a modification of the laser system 1 according to the first embodiment. In other words, a heat insulation member 72 is inserted into the space formed between a lower portion of the lid 7, which covers the laser section 8, and an upper portion of the base plate 11. The heat insulation member 72 effectively blocks heat from being transmitted on the route denoted by arrow C shown in Fig. 1. The heat insulation member 72 may be made of the same material as the heat insulation member 31 used in the laser system 21 according to the second embodiment.

In addition, a heat insulation member may be inserted into the similar space formed between the laser section and the base board of the laser system according to each of the first to third embodiments to block heat from being transmitted to the laser section.

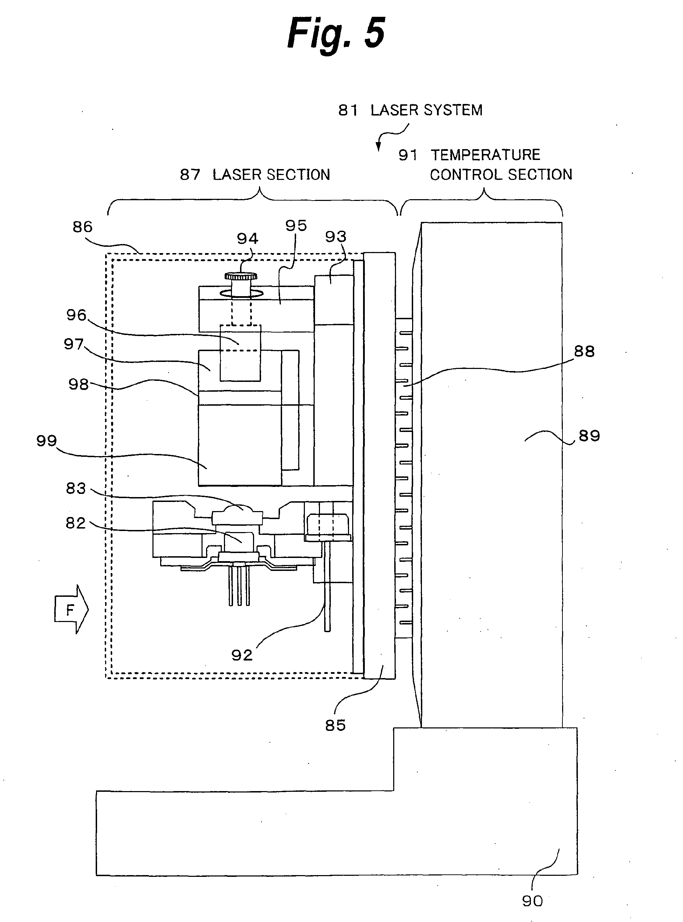

Fig. 5 shows a specific example of a laser system 81 that has a structure similar to the structure of the laser system 1 according to the first embodiment shown in Fig. 1. Fig. 5 shows a more specific structure of a laser section of the laser system 81. The orientation of reflected light of a grating 84 is the reverse of that of the foregoing laser systems. Fig. 6 is a side view showing the laser system 81 seen from the direction denoted by arrow F. Arrow G shown in Fig. 6 represents a path of light reflected by the grating 84. Fig. 5 shows the laser system 81 seen from the rear of the reflection surface of the grating 84.

The detailed structure of the laser section of the laser system 81 is different from the detailed structure of the laser section of the laser system 1 according to the first embodiment. The essence of the present invention is a structure of which heat generated in the laser section is effectively cooled down and the laser section is miniaturized. The laser section of the laser system according to each of the foregoing embodiments may be structured in various manners, not limited to those shown in the foregoing drawings. Thus, the specific structure of the laser section shown in Fig. 5 and Fig. 6 is just an example.

The laser system 81 is composed of a laser section 87 that has a laser diode 82, a lens 83, a grating 84, a second support member 85, a lid 86, and a temperature sensor 92 that measures the temperature of the laser section; and a temperature control section 91 that has a Peltier device 88, a heat sink 89, and a base plate 90.

In the laser section 87 of the laser system 81 according to this embodiment, the laser diode 82 does not have a window glass. The lens (collimate lens) 83 and the laser diode 82 block the light emission surface of the laser diode 82 from exposing to external air. In this structure, single mode laser light is emitted.

To keep the temperature of the laser section 87 constant, temperature detection means such as a temperature sensor 92 that measures the temperature of the laser section 87 is essential. While the value of temperature data obtained by the temperature sensor 92 is being monitored, the direction and amount of the current that flows to the Peltier device 88 are adjusted.

Next, the more specific structural portions shown in Fig. 5 and Fig. 6 will be described. A column 95 for a grating angle adjustment screw 94 is mounted on a mounting base designated by reference numeral 93. A reception member 96 that receives the tip of the grating angle adjustment screw 94 and that is made of a metal is mounted on a grating holder 97. The grating holder 97 is disposed on the mounting base 93.

The grating holder 97 is mounted at one end of a leaf spring 98. The other end of the leaf spring 98 is mounted on a column 99. The column 99 is mounted on the mounting base 93. By turning the grating angle adjustment screw 94, the angle of the grating 84 supported by the grating holder 97 can be adjusted.

The modifications according to the second to fourth embodiments may be applied to the laser system 81 shown in Fig. 5 and Fig. 6. The laser system 81 modified according to the second to fourth embodiments has the same effects as the second to fourth embodiments.

## Claims

1. A laser system, comprising:
a base plate;
a heat sink that is connected to the base plate and that is nearly perpendicular thereto;
a heat generation device or a heat absorption device that is connected to the heat sink and that is nearly perpendicular to the base plate; and
a laser section that is connected to the heat generation device or the heat absorption device and that is nearly perpendicular to the base plate, one surface of the heat generation device or the heat absorption device being connected to the laser section, the other surface of the heat generation device or the heat absorption device being connected to the heat sink,
wherein the laser section has a semiconductor laser device, a lens, a grating, and a support member, the semiconductor laser device, the lens, and the grating composing an external cavity type semiconductor laser, the support member supporting the external cavity type semiconductor laser,
wherein the laser section is connected to the heat generation device or the heat absorption device connected to the heat sink by the support member, and
wherein the external cavity type semiconductor laser is covered by the support member and a lid that has heat resistance.

2. The laser system as set forth in claim 1,
wherein the base plate and the heat sink are connected through a heat insulation member.

3. The laser system as set forth in claim 1,
wherein a space is formed between the base plate and the laser section, the space having a predetermined height.

4. The laser system as set forth in claim 3,
wherein the predetermined height is at least 10 mm.

5. The laser system as set forth in claim 4,
wherein a heat insulation member is disposed in the space having the predetermined height.

6. The laser system as set forth in claim 2,
wherein a space is formed between the base plate and the laser section, the space having a predetermined height.

7. The laser system as set forth in claim 6,
wherein the predetermined height is at least 10 mm.

8. The laser system as set forth in claim 7,
wherein a heat insulation member is disposed in the space having the predetermined height.

9. The laser system as set forth in claim 1,
wherein the heat generation device or the heat absorption device is a Peltier device.

10. The laser system as set forth in claim 1, further comprising:
temperature detection means for detecting the temperature of the laser section.

11. A laser system, comprising:
a heat sink that is directly connected to a surface plate and that is nearly perpendicular to the surface plate;
a heat generation device or a heat absorption device that is connected to the heat sink and that is nearly perpendicular to the surface plate; and
a laser section that is connected to the heat generation device or the heat absorption device and that is nearly perpendicular to the surface plate, one surface of the heat generation device or the heat absorption device being connected to the laser section, the other surface of the heat generation device or the heat absorption device being connected to the heat sink,
wherein the laser section has a semiconductor laser device, a lens, a grating, and a support member, the semiconductor laser device, the lens, and the grating composing an external cavity type semiconductor laser, the support member supporting the external cavity type semiconductor laser,
wherein the laser section is connected to the heat generation device or the heat absorption device connected to the heat sink by the support member, and
wherein the external cavity type semiconductor laser is covered by the support member and a lid that has heat resistance.

12. The laser system as set forth in claim 11,
wherein the surface plate and the heat sink are connected through a heat insulation member.

13. The laser system as set forth in claim 11,
wherein a space is formed between the surface plate and the laser section, the space having a predetermined height.

14. The laser system as set forth in claim 13,
wherein the predetermined height is at least 10 mm.

15. The laser system as set forth in claim 14,
wherein a heat insulation member is disposed in the space having the predetermined height.

16. The laser system as set forth in claim 12,
wherein a space is formed between the surface plate and the laser section, the space having a predetermined height.

17. The laser system as set forth in claim 16,
wherein the predetermined height is at least 10 mm.

18. The laser system as set forth in claim 17,
wherein a heat insulation member is disposed in the space having the predetermined height.

19. The laser system as set forth in claim 11,
wherein the heat generation device or the heat absorption device is a Peltier device.

20. The laser system as set forth in claim 11, further comprising:
temperature detection means for detecting the temperature of the laser section.
